# EUROPEAN PATENT SPECIFICATION

(11) **EP 3 890 190 B1**
(45) Date of publication and mention of the grant of the patent: **10.06.2026**
(21) Application number: 20193398.3
(22) Date of filing: 28.08.2020
(51) Int. Cl.: H03K 17/06, H03K 17/0812, H03K 17/689

(54) **GATE DRIVER CIRCUIT WITH REDUCED POWER SEMICONDUCTOR CONDUCTION LOSS**
GATE-TREIBERSCHALTUNG MIT REDUZIERTEM LEISTUNGSHALBLEITER-LEITUNGSVERLUST
CIRCUIT D'ATTAQUE DE GRILLE À PERTE DE CONDUCTION DE SEMI-CONDUCTEUR DE PUISSANCE RÉDUITE

(30) Priority: 01.04.2020 US 202016837896
(43) Date of publication of application: 06.10.2021
(73) Proprietor: Delta Electronics, Inc., Neihu, Taipei 11491 (TW)
(72) Inventor: Zhou, Yan, Canton, MI Michigan 48188 (US); Klesyk, Krzysztof, Novi, MI Michigan 48374 (US); Hampo, Richard Joseph, Ann Arbor, MI Michigan 48105 (US); Gui, Yingying, Novi, MI Michigan 48374 (US)
(74) Representative: Uexküll & Stolberg

(56) References cited:
- EP-A1- 2 916 458
- JP-A- 2012 049 946
- US-A1- 2004 036 511
- US-A1- 2009 066 402
- US-A1- 2016 226 386
- US-B1- 6 333 665

## Description

### FIELD OF THE INVENTION

The present invention relates to driver circuits for power semiconductor devices, such as driver circuits for insulated-gate bipolar transistors (IGBTs) or metal-oxide-semiconductor field-effect transistors (MOSFETs) in high-voltage, high-current applications.

### DISCUSSION OF THE RELATED ART

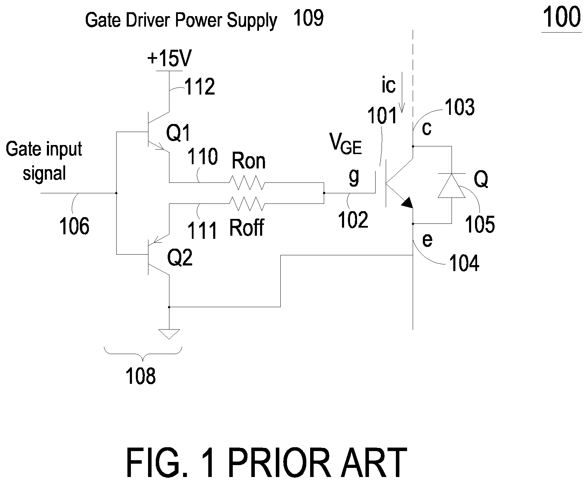

FIG. 1 shows a conventional gate driver circuit 100 for driving a gate terminal of a power semiconductor device 101. In FIG. 1, the power semiconductor device 101 is exemplified by an IGBT; however, the power semiconductor device 101 may be any one of numerous other devices (e.g., a MOSFET). As known to those of ordinary skill in the art, the conventional gate driver circuit 100 often includes also signal isolation, power supply, monitoring and protection circuits. These other circuits are omitted from FIG. 1, for clarity of illustration. As shown in FIG. 1, the gate driver circuit 100 includes (i) a buffer stage 108 formed, for example, by bipolar junction transistors (BJTs) NPN BJT Q₁ and PNP BJT Q₂; and (ii) turn-on and turn-off gate resistors Ron and Roff. The buffer stage 108 is connected between a power supply circuit 109 (e.g., + 15 volts) and the ground reference. The gate driver circuit 100 receives an input control signal 106 (e.g., an input control signal from a microprocessor) and provides an output signal at the gate terminal 102 of the IGBT 101. The input control signal 106 causes the buffer stage 108 to turn on either the NPN BJT Q₁ or the PNP BJT Q₂ to charge or discharge the gate terminal 102 of the IGBT 101. Although the NPN BJT Q₁ and PNP BJT Q₂ are used to illustrate the buffer stage 108, other switching devices, such as MOSFETs, may also be used to implement the buffer stage 108. When the input control signal 106 is at a high voltage, the NPN BJT Q₁ is conducting, thereby charging the capacitance of the gate terminal 102 of the IGBT 101 to the voltage of the power supply circuit 109 through the resistor Ron. Conversely, when the input control signal 106 is at a low voltage, the PNP BJT Q₂ is conducting, thereby discharging the capacitance at the gate terminal 102 of the IGBT 101 to ground through the resistor Roff.

Because of the transconductance of the IGBT 101, current i_{C} at a collector terminal 103 of the IGBT 101 is determined by the gate-emitter voltage (V_{GE}) across the gate terminal 102 and an emitter terminal 104 of the IGBT 101. The higher voltage V_{GE} is, the higher is current i_{C}, which results in a lower collector-emitter voltage (V_{CE}) at which current i_{C} becomes saturated. To achieve the lowest possible conduction losses, a high voltage from the power supply circuit 109 is preferred. However, the resulting higher gate-emitter voltage V_{GE} may result in a correspondingly higher short-circuit current, if a short-circuit condition occurs. This is because, under a short circuit condition, the higher gate-emitter voltage (V_{GE}) causes the collector current i_{C} to increase more rapidly than when a lower gate-emitter voltage is present. Also, as the gate terminal 102 is fully charged, the collector current i_{C} has a higher value, as the IGBT 101 is operating at a higher desaturation current level. Taking all these factors into consideration, the output voltage of the power supply circuit 109 is usually selected, as a tradeoff, to be +15 volts.

Various schemes to improve the gate driver circuit of a power semiconductor device are known in the prior art. For example, U.S. Patent 7,265,601 ("Ahmad"), entitled "Adaptive Gate Drive Voltage Circuit", discloses a method that reduces losses in a DC/DC converter by optimizing gate drive voltage. In Ahmad, the driver circuit adjusts the gate voltage based on the output load current; specifically, the gate voltage is reduced at a low load current and increased at a high load current. As another example, U.S. Patent 9,444,448 ("Wagoner"), entitled "High performance IGBT gate drive", discloses applying one or more intermediate voltages near the IGBT's threshold voltage to control the rate of change of the collector-emitter voltage and the rate of change of the collector current during turn-off. Wagoner's scheme optimizes for reducing switching loss.

US 2009/066402 A1 discloses a gate drive circuit including a turn-on side circuit for turning on a gate of a power switching device, the turn-on side circuit including a first turn-on side power supply circuit and a second turn-on side power supply circuit, the first turn-on side power supply circuit including: a first turn-on voltage source for supplying a first turn-on voltage; first turn-on wiring; and a first turn-on switch connected in the first turn-on wiring and controlled by a gate drive signal; and the second turn-on side power supply circuit including: a second turn-on voltage source for supplying a second turn-on voltage applied to the gate of the power switching device to set the power switching device in a steady (on) state; second turn-on wiring; a second turn-on switch connected in the second turn-on wiring; and a turn-on side delay circuit for delaying the gate drive signal and passing it to the second turn-on switch.

US 6,333,665 B1 relates to a gate circuit for controlling an insulated gate semiconductor device having a gate terminal, comprising: positive and negative control power source terminals; first and second semiconductor device groups, in which a plurality of semiconductor devices are connected in series between said positive and negative control power source terminals; a switching signal source for supplying ON/OFF control signals to said semiconductor devices of the first and second semiconductor device groups; and delay circuits for delaying said ON/OFF control signals supplied from said switching signal source to one or other of said first or second semiconductor device groups during a predetermined time, wherein a mid-point of said first semiconductor device group is connected to said gate terminal of said insulated gate semiconductor device, respective collectors of said first semiconductor device group are connected to said positive and negative control power source terminals via respective resistors, and a central connecting point of said second semiconductor device group is connected to said gate terminal of said insulated gate semiconductor device.

US 2004/036511 A1 describes a driver for a switching device having a plurality of driver circuits for driving the switching device and a control circuit. The control circuit selectively operates the driver circuits in response to a plurality of predetermined drive modes. Alternatively, a driver for a switching device has a driver circuit and a control circuit. The driver circuit is connected to a plurality of power sources. Each of the power sources has a different voltage. The control circuit selects one of the power sources for operating the driver circuit in response to a plurality of predetermined drive modes.

### SUMMARY

An apparatus according to the invention is defined in the appended independent claim. Preferred embodiments are defined in the dependent claims.

The present invention is better understood upon consideration of the detailed description below in conjunction with the drawings.

### BRIEF DESCRIPTION OF THE DRAWINGS

FIG. 1 shows a conventional gate driver circuit 100 for driving a gate terminal of a power semiconductor device 101;
FIG. 2 shows a gate driver circuit 200 in accordance with one embodiment of the present invention;
FIG. 3 illustrates an operation of a power supply selector circuit 203 in accordance with one embodiment of the present invention; and
FIG. 4 shows a gate driver circuit 400, which is one implementation of the gate driver circuit 200 of FIG. 2.

To facilitate cross-referencing among the FIG.s, like elements are assigned like reference numerals.

### DETAILED DESCRIPTION OF THE PREFERRED EMBODIMENTS

The present disclosure will now be described more specifically with reference to the following embodiments. It is to be noted that the following descriptions of preferred embodiments of this disclosure are presented herein for purpose of illustration and description only. It is not intended to be exhaustive or to be limited to the precise form disclosed.

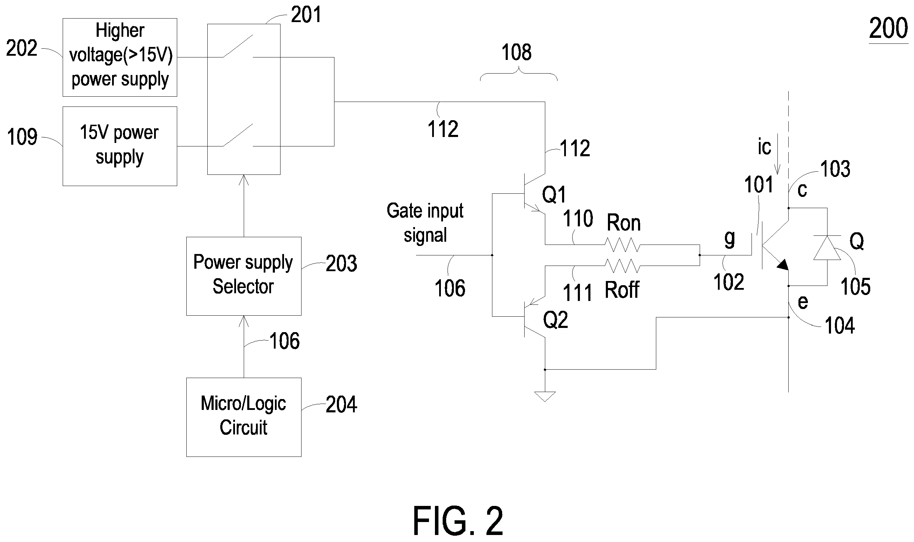

The present invention provides a gate driver circuit that provides an adjustable output power supply voltage for driving a gate terminal of a power semiconductor device. The adjustable output power supply voltage reduces the saturation voltage in the power semiconductor device during turn-on, without compromising its desirable short-circuit current characteristics. FIG. 2 shows a gate driver circuit 200 in accordance with one embodiment of the present invention. In FIG. 2, in addition to a power supply circuit 109, buffer stage 108, turn-on and turn-off resistors Ron and Roff of FIG. 1, the gate driver circuit 200 also includes a higher-voltage power supply circuit 202, a power supply selection circuit 201, a power supply selector circuit 203 and a control circuit 204. In the gate driver circuit 200, the power supply selector circuit 203 causes the power supply selection circuit 201 to select the output voltage of either the power supply circuit 109 or the higher-voltage power supply circuit 202 to place at a terminal 112 as the power supply voltage to drive a gate terminal 102 of an IGBT 101, during different times of the IGBT operations. The higher-voltage power supply circuit 202 provides at the terminal 112 a higher voltage (e.g., 18.5 volts) than the voltage (e.g., 15 volts) supplied by the power supply circuit 109. The power supply selection circuit 201 may be implemented by one or more semiconductor switches and the power supply selector circuit 203 may be implemented by a logic circuit that operates the switches in the power supply selection circuit 201.

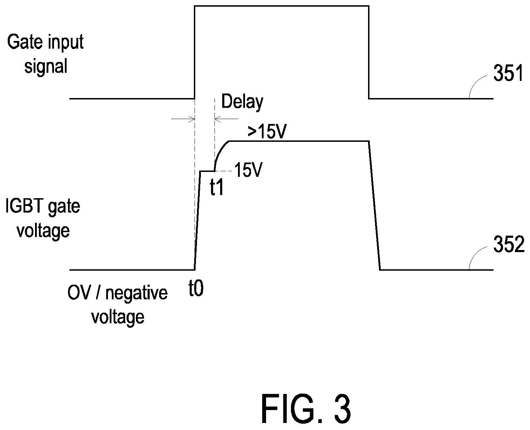

FIG. 3 illustrates an operation of the power supply selector circuit 203 in accordance with one embodiment of the present invention. As shown in FIG. 3, waveform 351 represents an input control signal 106 received into the buffer stage 108 and the power supply selector circuit 203. Waveform 352 represents the voltage waveform at the gate terminal 102. When the IGBT 101 is turned off, the voltage at the terminal 112 is provided by the power supply circuit 109 (i.e., 15 volts). When the input control signal 106 goes high at time t₀, turn-on transistor Q₁ turns on and the gate terminal 102 of the IGBT 101 goes to the lower supply voltage (i.e., 15 volts), such that collector current i_{C} increases at a limited slew rate. Therefore, if a short-circuit condition exists at this time, the short-circuit current is limited by the lower power supply voltage. With the lower power supply voltage at its gate terminal 102, the desaturation current in the IGBT 101 is also limited.

After a predetermined delay (i.e., time interval (t₁ - t₀)), the power supply selector circuit 203 causes the voltage at the terminal 112 to be sourced from the higher-voltage power supply 202 (e.g., at 18.5 volts), which increases the voltage at the gate terminal 102 of the IGBT 101. At this higher voltage, the IGBT 101's saturation voltage across a collector terminal 103 and an emitter terminal 104 (i.e., V_{CE}) is reduced. When the input control signal 106 returns to low, the power supply selector circuit 203 causes the voltage at the terminal 112 to be sourced from the power supply circuit 109 (i.e., returning the voltage at the terminal 112 to 15 volts). In some embodiments, the transition between the power supply circuit 109 to the higher-voltage power supply circuit 202 (i.e., from 15 volts to 18.5 volts), and vice versa, can occur gradually over a predetermined time period. For example, the transition can be controlled by an RC circuit; in that case, the voltage at the terminal 112 rises or falls at a rate that may be characterized by a time constant.

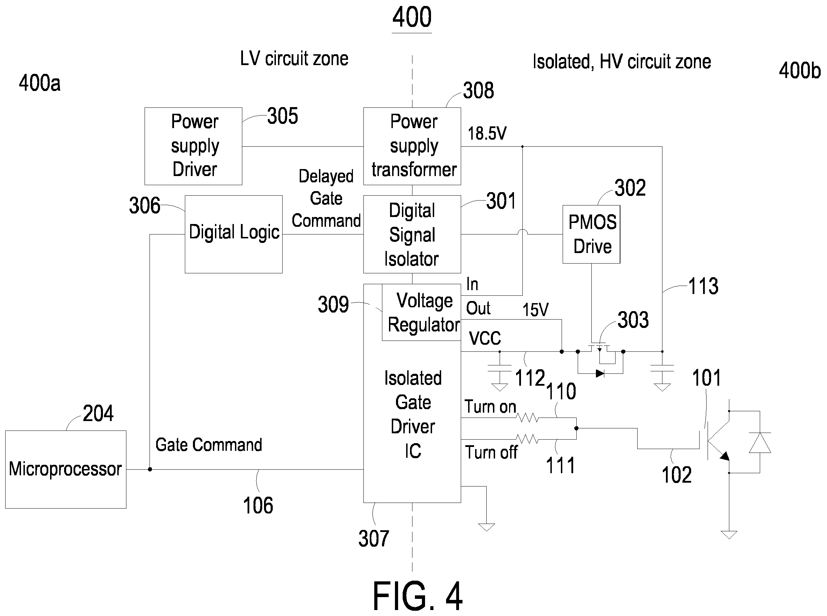

FIG. 4 shows a gate driver circuit 400, which is one implementation of the gate driver circuit 200 of FIG. 2. As shown in FIG. 4, the circuitry of the gate driver circuit 400 is divided into a low-voltage domain 400a and a high-voltage domain 400b. The low-voltage domain 400a includes logic circuits that provide the control functions of the gate driver circuit 400, and the high-voltage domain 400b includes a high-voltage circuitry that drives the gate terminal 102 of the IGBT 101. Circuitry in the low-voltage domain 400a may be isolated from circuitry in the high-voltage domain 400b using conventional isolation techniques, such as optical isolation or other semiconductor devices.

As show in FIG. 4, a power supply transformer 308 implements the higher supply voltage (e.g., 18.5 volts) of the higher-voltage power supply circuit 202 of FIG. 2. The power supply transformer 308 is enabled and initialized by a low-voltage logic circuit (i.e., power supply driver 305). The control circuit 204 of FIG. 2 is implemented in the gate driver circuit 400 by a microprocessor 204, which issues the input control signal 106 to a logic circuit 306 and an isolated gate driver integrated circuit 307. The isolated gate driver integrated circuit 307, which receives the higher supply voltage from the higher-voltage power supply circuit 202, includes a voltage regulator 309 which provides a regulated output voltage (e.g., 15 volts) on the terminal 112. In this manner, the isolated gate driver integrated circuit 307 implements the power supply circuit 109. In addition, the buffer stage 108 is also implemented in the isolated gate driver integrated circuit 307 by supplying the voltage at the terminal 112 to a terminal 110 during turn-on and by grounding terminal 111 during turn-off. The isolated gate driver integrated circuit 307 may be implemented by, for example, an MC33GD3100 integrated circuit from NXP semiconductors N.V.

In one embodiment, the digital logic circuit 306 delays the input control signal 106 by the predetermine delay (e.g., time interval (t₁ - t₀) in FIG. 3). The delayed input control signal 106 enters the high-voltage domain 400b through the digital signal isolator circuit 301 to turn on PMOS driver 302 which, in turn, turns on a PMOS transistor 303. Conducting the PMOS transistor 303 places the higher supply voltage of the power supply transformer 308 on the terminal 112. The PMOS driver 302 may be implemented by a bipolar transistor (e.g., a un2217 bipolar transistor) driving an RC circuit that achieves a more gradual slew rate (i.e., with an RC time constant) to transition to the higher supply voltage. As the voltage at the terminal 112 rises, the voltage regulator 309 turns off, and the higher supply voltage is provided on the terminal 110 of the turn-on resistor Ron. During turn-off, the PMOS driver 302 turns off the PMOS transistor 303 and the terminal 112 returns to the regulated output voltage of the voltage regulator 309.

Without impacting short-circuit performance, the method of the present invention drives the gate terminal of a power semiconductor device at a higher power supply voltage to achieve a reduced saturation voltage in the power semiconductor device during conduction. In this manner, the trade-off in a conventional gate driver circuit between a lower saturation voltage when the power semiconductor device is conducting and a high short-circuit current is avoided. Since the voltage at the gate terminal of the power semiconductor device is increased during its conducting state, the power semiconductor device's conduction loss is reduced, thereby resulting in both enhanced system efficiency and a reduced thermal stress.

## Claims

1. A gate driver circuit (200, 400) configured to receive an input control signal (106) and configured to provide a voltage at a node of the gate driver circuit (200,400) connectable to a gate terminal (102) of a semiconductor switching device (101), comprising:
a first voltage source (202) configured to provide a first voltage;
a second voltage source (109) configured to provide a second voltage, wherein the first voltage is higher than the second voltage;
a resistor (Ron), electrically connected to the gate terminal (102); and
a selector circuit (203) configured to select either the first voltage or the second voltage to be coupled to the gate terminal (102) of the semiconductor switching device (101) through the resistor (Ron) based on an input control signal's logic state, the selector circuit (203) comprises:
a first transistor (303) configured to provide the first voltage source (202) to the gate terminal (102) of the semiconductor switching device (101) in a conducting state, the first transistor (303) having a gate terminal that receives an enable signal that causes it to switch between the conducting state and a non-conducting state; and
a second transistor (302) configured to receive the input control signal (106) delayed for a predetermined time interval by the selector circuit (203) and configured to provide the enable signal to the gate terminal of the first transistor (303) according to the input control signal's logic state,
a buffer stage (108) connected between a power supply terminal (112) and a ground reference, wherein the selector circuit (203) provides the selected voltage at the power supply terminal (112) of the buffer stage (108),
wherein the buffer stage (108) has an output terminal coupled to the gate terminal (102) of the semiconductor switching device (101), and wherein the buffer stage (108) provides the voltage at its power supply terminal (112) to its output terminal based on the input control signal's logic state,
wherein the output terminal of the buffer stage (108) is coupled to the gate terminal (102) of the semiconductor switching device (101) by the resistor (Ron).

2. The gate driver circuit (200, 400) of claim 1, further comprising an RC circuit in the signal path of the enable signal, such that when the first transistor (303) connects the first voltage source (202) to the gate terminal (102) of the semiconductor switching device (101), the voltage at the gate terminal (102) of the semiconductor switching device (101) rises to the first voltage at a slew rate determined by the RC circuit.

3. The gate driver circuit (200, 400) of claim 1, comprising a high-voltage domain (400b) and a low-voltage domain (400a) that are isolated from each other, wherein the first and the second voltages are signals in the high-voltage domain (400b) and wherein the input control signal (106) is a signal in the low-voltage domain (400a).

4. The gate driver circuit (200, 400) of claim 1, wherein the input control signal (106) is received from a control circuit (204) connectable to the gate driver circuit (200,400).

5. The gate driver circuit (200, 400) of claim 4, wherein the control circuit (204) comprises a microprocessor (204).

## Patentansprüche

1. Gate-Treiberschaltung (200, 400), die ausgestaltet ist, um ein Eingangssteuersignal (106) zu empfangen, und ausgestaltet ist, um eine Spannung an einem Knoten der Gate-Treiberschaltung (200, 400) zur Verfügung zu stellen, der mit einem Gate-Anschluss (102) einer Halbleiter-Schaltvorrichtung (101) verbunden werden kann, umfassend:
eine erste Spannungsquelle (202), die ausgestaltet ist, um eine erste Spannung zur Verfügung zu stellen;
eine zweite Spannungsquelle (109), die ausgestaltet ist, um eine zweite Spannung zur Verfügung zu stellen, wobei die erste Spannung höher ist als die zweite Spannung;
einen Widerstand (Ron), der elektrisch mit dem Gate-Anschluss (102) verbunden ist; und
eine Auswahlschaltung (203), die ausgestaltet ist, um basierend auf dem logischen Zustand eines Eingangssteuersignals auszuwählen, ob entweder die erste Spannung oder die zweite Spannung über den Widerstand (Ron) mit dem Gate-Anschluss (102) der Halbleiter-Schaltvorrichtung (101) gekoppelt werden soll, wobei die Auswahlschaltung (203) umfasst:
einen ersten Transistor (303), der ausgestaltet ist, um die erste Spannungsquelle (202) in einem leitenden Zustand an den Gate-Anschluss (102) der Halbleiter-Schaltvorrichtung (101) zu liefern, wobei der erste Transistor (303) einen Gate-Anschluss aufweist, der ein Aktivierungssignal empfängt, das bewirkt, dass er zwischen dem leitenden Zustand und einem nichtleitenden Zustand umschaltet; und
einen zweiten Transistor (302), der ausgestaltet ist, um das durch die Auswahlschaltung (203) um ein vorbestimmtes Zeitintervall verzögerte Eingangssteuersignal (106) zu empfangen, und ausgestaltet ist, um das Aktivierungssignal entsprechend dem logischen Zustand des Eingangssteuersignals an den Gate-Anschluss des ersten Transistors (303) zu liefern,
eine Pufferstufe (108), die zwischen einem Stromversorgungsanschluss (112) und einer Masse-Referenz angeschlossen ist, wobei die Auswahlschaltung (203) die ausgewählte Spannung am Stromversorgungsanschluss (112) an die Pufferstufe (108) liefert,
wobei die Pufferstufe (108) einen Ausgangsanschluss aufweist, der mit dem Gate-Anschluss (102) der Halbleiter-Schaltvorrichtung (101) gekoppelt ist, und wobei die Pufferstufe (108) die Spannung an ihrem Stromversorgungsanschluss (112) basierend auf dem logischen Zustand des Eingangssteuersignals an ihren Ausgangsanschluss liefert,
wobei der Ausgangsanschluss der Pufferstufe (108) über den Widerstand (Ron) mit dem Gate-Anschluss (102) der Halbleiter-Schaltvorrichtung (101) gekoppelt ist.

2. Gate-Treiberschaltung (200, 400) nach Anspruch 1, ferner umfassend eine RC-Schaltung in dem Signalpfad des Aktivierungssignals, so dass, wenn der erste Transistor (303) die erste Spannungsquelle (202) mit dem Gate-Anschluss (102) der Halbleiter-Schaltvorrichtung (101) verbindet, die Spannung an dem Gate-Anschluss (102) der Halbleiter-Schaltvorrichtung (101) mit einer durch die RC-Schaltung bestimmten Anstiegsgeschwindigkeit auf die erste Spannung ansteigt.

3. Gate-Treiberschaltung (200, 400) nach Anspruch 1, umfassend eine Hochspannungsdomäne (400b) und eine Niederspannungsdomäne (400a), die voneinander isoliert sind, wobei die erste und die zweite Spannung Signale in der Hochspannungsdomäne (400b) sind und wobei das Eingangssteuersignal (106) ein Signal in der Niederspannungsdomäne (400a) ist.

4. Gate-Treiber-Schaltung (200, 400) nach Anspruch 1, wobei das Eingangssteuersignal (106) von einer Steuerschaltung (204) empfangen wird, die mit der Gate-Treiberschaltung (200, 400) verbunden werden kann.

5. Gate-Treiberschaltung (200, 400) nach Anspruch 4, wobei die Steuerschaltung (204) einen Mikroprozessor (204) umfasst.

## Revendications

1. Circuit d'attaque de grille (200, 400) configuré pour recevoir un signal de commande d'entrée (106) et configuré pour fournir une tension à un nœud du circuit d'attaque de grille (200, 400) connectable à une borne de grille (102) d'un dispositif de commutation à semi-conducteur (101), comprenant:
une première source de tension (202) configurée pour fournir une première tension;
une deuxième source de tension (109) configurée pour fournir une deuxième tension, la première tension étant supérieure à la deuxième tension;
une résistance (Ron), connectée électriquement à la borne de grille (102); et
un circuit sélecteur (203) configuré pour sélectionner soit la première tension soit la deuxième tension à coupler à la borne de grille (102) du dispositif de commutation à semi-conducteur (101) par l'intermédiaire de la résistance (Ron) sur la base d'un état logique du signal de commande d'entrée, le circuit sélecteur (203) comprenant:
un premier transistor (303) configuré pour fournir la première source de tension (202) à la borne de grille (102) du dispositif de commutation à semi-conducteur (101) dans un état conducteur, le premier transistor (303) ayant une borne de grille qui reçoit un signal de validation qui l'amène à commuter entre l'état conducteur et un état non conducteur; et
un deuxième transistor (302) configuré pour recevoir le signal de commande d'entrée (106) retardé d'un intervalle de temps prédéterminé par le circuit sélecteur (203) et configuré pour fournir le signal de validation à la borne de grille du premier transistor (303) selon l'état logique du signal de commande d'entrée,
un étage tampon (108) connecté entre une borne d'alimentation électrique (112) et une référence de masse, le circuit sélecteur (203) fournissant la tension sélectionnée à la borne d'alimentation électrique (112) de l'étage tampon (108),
dans lequel l'étage tampon (108) a une borne de sortie couplée à la borne de grille (102) du dispositif de commutation à semi-conducteur (101), et dans lequel l'étage tampon (108) fournit la tension présente à sa borne d'alimentation électrique (112) à sa borne de sortie sur la base de l'état logique du signal de commande d'entrée,
dans lequel la borne de sortie de l'étage tampon (108) est couplée à la borne de grille (102) du dispositif de commutation à semi-conducteur (101) par la résistance (Ron).

2. Circuit d'attaque de grille (200, 400) selon la revendication 1, comprenant en outre un circuit RC dans le chemin de signal du signal de validation, de telle sorte que lorsque le premier transistor (303) connecte la première source de tension (202) à la borne de grille (102) du dispositif de commutation à semi-conducteur (101), la tension présente à la borne de grille (102) du dispositif de commutation à semi-conducteur (101) monte jusqu'à la première tension à une vitesse de balayage déterminée par le circuit RC.

3. Circuit d'attaque de grille (200, 400) selon la revendication 1, comprenant un domaine haute tension (400b) et un domaine basse tension (400a) qui sont isolés l'un de l'autre, dans lequel les première et deuxième tensions sont des signaux dans le domaine haute tension (400b) et dans lequel le signal de commande d'entrée (106) est un signal dans le domaine basse tension (400a).

4. Circuit d'attaque de grille (200, 400) selon la revendication 1, dans lequel le signal de commande d'entrée (106) est reçu d'un circuit de commande (204) connectable au circuit d'attaque de grille (200, 400).

5. Circuit d'attaque de grille (200, 400) selon la revendication 4, dans lequel le circuit de commande (204) comprend un microprocesseur (204).
